(19) Europäisches Patentamt
European Patent Office
Office européen des brevets

(11) Veröffentlichungsnummer: **0 099 860**
**A2**

(12) # EUROPÄISCHE PATENTANMELDUNG

(21) Anmeldenummer: 83810322.4

(22) Anmeldetag: 15.07.83

(51) Int. Cl.[3]: **H 01 L 31/18**
H 01 L 31/02

(30) Priorität: 21.07.82 CH 4451/82

(43) Veröffentlichungstag der Anmeldung:
01.02.84 Patentblatt 84/5

(84) Benannte Vertragsstaaten:
CH DE FR GB IT LI

(71) Anmelder: CIBA-GEIGY AG
Patentabteilung Postfach
CH-4002 Basel(CH)

(72) Erfinder: Reber, Jean-François, Dr.
Gstaltenrainweg 69
CH-4125 Riehen(CH)

(72) Erfinder: Bühler, Niklaus, Dr.
Route du Pâquier 8
CH-1723 Marly(CH)

(72) Erfinder: Meier, Kurt, Dr.
Ulmenstrasse 11
CH-4123 Allschwil(CH)

(72) Erfinder: Rusek, Milos
Tiefengrabenstrasse 49
CH-4102 Binningen(CH)

(54) **Verfahren zur thermischen Behandlung von Halbleiterpulvern.**

(57) Es wird ein Verfahren zur thermischen Behandlung von Halbleiterpulvern beschrieben, indem man bei einem Druck von 100 bis $10^6$ Pa

a) Halbleiterpulver aus CdS, CdSe, CdTe, $CdS_{1-x}Se_x$, $CdS_{1-x}Te_x$, $CdSe_{1-x}Te_x$, $Cd_{1-x}Zn_xS$, $Cd_{1-y}Ag_{2y}S$ oder $Cd_{1-y}Cu_yS$ in Gegenwart von $H_2S$, $H_2Se$, $H_2Te$ und/oder $CS_2$, gegebenenfalls im Gemisch mit Inertgasen und/oder mit bis zu 50 Volumenprozent $O_2$ oder Gegenwart eines Gemisches aus Inertgasen und bis zu 50 Volumenprozent $O_2$ beim Siedepunkt des Cadmiums bei dem jeweils angewendeten Druck ± 100°C oder

b) Halbleiterpulver aus ZnS, ZnSe, ZnTe, $ZnS_{1-x}$, $Se_x$, $ZnS_{1-x}Te_x$, $ZnSe_{1-x}Te_x$, $Zn_{1-y}Ag_{2y}S$ oder $Zn_{1-y}Cu_yS$ in Gegenwart von $H_2S$, $H_2Se$, $H_2Te$ und/oder $CS_2$, gegebenenfalls im Gemisch mit Inertgasen oder bis zu 50 Volumenprozent $O_2$ beim Siedepunkt des Zinks bei dem jeweils angewendeten Druck ± 150°C behandelt, wobei x 0,01 bis 0,99 und y 0,0001 bis 0,20 sind.

Die so erhaltenen Halbleiterpulver weisen verbesserte Photoredoxeigenschaften auf und eignen sich z.B. zur Anwendung in Photodioden, synthetischen photogalvanischen oder photoelektrolytischen Zellen oder zur Produktion von Wasserstoff mittels heterogener Photoredoxkatalyse. Zu diesem Zweck werden die thermisch vorbehandelten Halbleiterpulver mindestens teilweise mit Cu, Cr, Ni, Co oder einem Edelmetall, vor allem Platin, beschichtet.

EP 0 099 860 A2

CIBA-GEIGY AG
Basel (Schweiz)

6-14022/=

# Verfahren zur thermischen Behandlung von Halbleiterpulvern

Die vorliegende Erfindung betrifft ein neues Verfahren zur thermischen Behandlung von Halbleiterpulvern und die damit erhältlichen Halbleiterpulver.

Aus der U.S. Patentschrift 4.254.093 ist bekannt, dass man durch thermische Behandlung Cadmiumsulfidpulver mit relativ grosser Teilchengrösse und einer bestimmten Dichte herstellen kann, die sich besonders für Anwendungen zur Ausnutzung der Sonnenenergie, vor allem photovoltaische Geräte (Zellen) eignen. Dabei wird chemisch ausgefälltes hochreines Cadmiumsulfid (mindestens 97%ig ) in einer ersten Stufe unter Inertgas, wie $N_2$, auf 450-550°C erhitzt und dann bei Temperaturen zwischen 1000 und 1100°C mit $H_2S$ oder $CS_2$ behandelt. Anschliessend wird das Cadmiumsulfid zuerst unter $H_2S$ oder $CS_2$ auf 450-550°C und dann unter Inertgas auf Raumtemperatur abgekühlt. Es ist auch bekannt, dass Zinksulfid durch thermische Behandlung mit verschiedenen Gasen von Verunreinigungen, wie Kohlenstoff oder Schwefel,befreit oder die Farbe oder Kristallinität von u.a.CdS- oder ZnS/CdS-Pigmenten beeinflusst werden können. So sollen gemäss Nippon Kagaku Kaishi (10), 1788-94(1972) die Brillanz und Kristallinität von CdS- und ZnS/CdS-Pigmenten durch Behandlung mit Sauerstoff bei 400-700°C verbessert werden, während eine analoge Behandlung mit Stickstoff oder Helium diesbezüglich praktisch keine Veränderungen bewirkt. Für die Reinigung von Zinksulfid eignen sich je nach verwendetem Gas ganz unterschiedliche Temperaturen, z.B. 850-980°C in CO-Atmosphäre bei einem Druck von ca. 13 bis 70 Pa und 460 - 650°C, bevorzugt 460-500°C, unter $H_2S$ bei Normaldruck [vgl. z.B. SU Patent 763.274 und U.S. Patentschrift 3.131.026].

Es wurde nun gefunden, dass man durch die Wahl ganz spezifischer Reaktionsbedingungen Halbleiterpulver mit wesentlich verbesserten Photoredoxeigenschaften erhalten kann, indem man bei einem Druck von 100 bis $10^6$ Pa

a) Halbleiterpulver aus CdS, CdSe, CdTe, $CdS_{1-x}Se_x$, $CdS_{1-x}Te_x$, $CdSe_{1-x}Te_x$, $Cd_{1-x}Zn_xS$, $Cd_{1-y}Ag_{2y}S$ oder $Cd_{1-y}Cu_yS$ in Gegenwart von $H_2S$, $H_2Se$, $H_2Te$ und/oder $CS_2$, gegebenenfalls im Gemisch mit Inertgasen und/oder mit bis zu 50 Volumenprozent $O_2$ oder in Gegenwart eines Gemisches aus Inertgasen und bis zu 50 Volumenprozent $O_2$ beim Siedepunkt des Cadmiums bei dem jeweils angewendeten Druck $\pm$ 100°C oder

b) Halbleiterpulver aus ZnS, ZnSe, ZnTe, $ZnS_{1-x}Se_x$, $ZnS_{1-x}Te_x$, $ZnSe_{1-x}Te_x$, $Zn_{1-y}Ag_{2y}S$ oder $Zn_{1-y}Cu_yS$ in Gegenwart von $H_2S$, $H_2Se$, $H_2Te$ und/oder $CS_2$, gegebenenfalls im Gemisch mit Inertgasen oder bis zu 50 Volumenprozent $O_2$ beim Siedepunkt des Zinks bei dem jeweils angewendeten Druck $\pm$150°C

behandelt, wobei x 0,01 bis 0,99 und y 0,0001 bis 0,20 sind.

Die thermische Behandlung gemäss Verfahrensvariante a) ist bevorzugt.

Als Inertgase kommen z.B. $H_2$, $N_2$, He, Ne, Ar, Kr, Xe oder $CO_2$ in Betracht. Bevorzugtes Inertgas ist Stickstoff. Der Anteil an Sauerstoff in definitionsgemässen Gasgemischen liegt zweckmässig unter 30 Vol.%. Als Gemische von Inertgasen mit $O_2$ kann auch Luft verwendet werden.

x ist bevorzugt 0,01 bis 0,4, besonders 0,05 bis 0,2, und y stellt vor allem 0,001 bis 0,2, besonders 0,002 bis 0,05 dar.

Bevorzugt verwendet man ZnS- oder $ZnS_{1-x}$-$Se_x$-Halbleiterpulver und vor allem CdS-, $CdS_{1-x}Se_x$-, $Cd_{1-x}Zn_xS$- oder $Cd_{1-y}Ag_{2y}S$-Halbleiterpulver, worin x 0,01 bis 0,4, besonders 0,05 bis 0,2, und y 0,001 bis 0,2, besonders 0,002 bis 0,05 sind.

Die thermische Behandlung wird mit Vorteil bei einem Druck von 1000 bis $2 \times 10^5$ Pa und besonders bevorzugt bei Normaldruck durchgeführt.

Als Gase für die Behandlung von Halbleiterpulvern gemäss Verfahrensvariante a) setzt man vorzugsweise $H_2S$ oder Luft oder Gemische davon ein, während für die Behandlung von Halbleiterpulvern gemäss Verfahrensvariante b), besonders von ZnS- oder $ZnS_{1-x}Se_x$-Halbleiterpulvern mit x = 0,01 bis 0,4, $H_2S$ als Gas bevorzugt ist.

Die Reaktionszeiten können innerhalb weiter Grenzen variieren und liegen im allgemeinen zwischen 1 Minute und 50 Stunden, besonders zwischen 1 Minute und 10 Stunden.

Gemäss einer besonders bevorzugten Ausführungsform wird ein CdS- oder $Cd_{1-x}Zn_xS$-Halbleiterpulver mit x = 0,05 bis 0,2 bei Normaldruck in Gegenwart von $H_2S$ bei 760 $\pm$ 60°C behandelt. Gemäss einer weiteren Bevorzugung wird ein CdS-Halbleiterpulver bei Normaldruck in Gegenwart von Luft bei 760 $\pm$ 60°C behandelt. Dabei dauert die thermische Behandlung mit Vorteil zwischen 1 und 20 Minuten.

Als Halbleiterpulver können sowohl solche technischer Qualität als auch hochreine Pulver eingesetzt werden. Die spezifische Oberfläche der als Ausgangsprodukte eingesetzten Halbleiter kann innerhalb weiter Grenzen variieren und liegt im allgemeinen zwischen 0,1 und 200 $m^2/g$, bevorzugt zwischen 0,5 und 100 $m^2/g$.

Das erfindungsgemässe Verfahren kann z.B. so durchgeführt werden, dass man die Halbleiterpulver zuerst einer Vorbehandlung unter einem Inertgas der vorerwähnten Art bei tieferen Temperaturen, bevorzugt zwischen etwa 200 und 500°C, besonders 400 und 500°C, unterzieht und dann die thermische Behandlung bei erhöhter Temperatur durchführt. Eine solche Vorbehandlung unter Inertgas ist aber nicht unbedingt erforderlich. Nach der thermischen Behandlung wird vorzugsweise stufenweise auf Raumtemperatur abgekühlt, und zwar im allgemeinen zuerst unter dem für die thermische Behandlung eingesetzten Gas oder Gasgemisch auf Temperaturen von vorzugsweise unter 500°C, und dann erneut unter Inertgasatmosphäre oder Luft auf Raumtemperatur. Als Inertgas ist dabei $N_2$ bevorzugt. Die Gase werden zweckmässig mit einer Durchflussgeschwindigkeit eingeleitet, die bis zum zehnfachen Gaswechsel im Reaktor pro Stunde reicht.

Mit dem erfindungsgemässen Verfahren werden Halbleiterpulver mit verbesserter Kristallinität erhalten, ohne dass dabei eine Veränderung der Teilchengrösse der Pulver oder ein Zusammenbacken der Pulverteilchen eintritt. Gleichzeitig bewirkt die erfindungsgemässe thermische Behandlung im allgemeinen auch eine wesentliche Verringerung der spezifischen Oberfläche der Halbleiterpulver, die auf einer verminderten Porosität der Pulver beruht. Ein weiterer Vorteil des erfindungsgemässen Verfahrens besteht darin, dass mit gleichbleibendem Erfolg auch Halbleiterpulver sogenannter technischer Qualität, wie z.B. ein Cadmiumsulfid nach Colour Index Nr. 77199, das einen Reinheitsgrad von etwa 90% aufweist, eingesetzt werden können.

Die erfindungsgemäss erhaltenen Halbleiterpulver eignen sich beispielsweise zur Anwendung in Photodioden, wie sie z.B. in Encyclopedia of Chemical Technology, Bd. 17, 3. Auflage, Kirk-Othmer, John Wiley, New York (1982), Seiten 560-611 und 709-732 beschrieben sind, oder in synthetischen photogalvanischen oder photoelektrolytischen Zellen [vgl. z.B. die genannte Literaturstelle, Seiten 709-732, und Electrochimica Acta, 25, 29(1980)], insbesondere jedoch zur Produktion von Wasserstoff mittels heterogener Photoredoxkatalyse. Zu diesem Zweck werden sie mindestens teilweise mit Cu, Cr, Ni, Co oder einem Edelmetall oder Gemischen davon beschichtet und dann z.B. in Gegenwart von Gemischen aus Wasser und Alkalimetall-, Erdalkalimetall- oder Ammoniumsulfiten, -sulfiden, -hypophosphiten, -phosphiten und/oder den entsprechenden freien Säuren unter Lichteinwirkung zur Reaktion gebracht. Eine typische Reaktion kann wie folgt schematisch veranschaulicht werden:

$$SO_3^{-2} + H_2O \longrightarrow SO_4^{-2} + 2H^+ + 2e^- \qquad \text{(Oxidation)}$$

$$2H^+ + 2e^- \longrightarrow H_2 \qquad \text{(Reduktion)}$$

---

$$SO_3^{-2} + H_2O \longrightarrow SO_4^{-2} + H_2 \qquad \text{(Gesamtreaktion)}.$$

Die dabei einzusetzenden Ausgangsmaterialien sind leicht zugänglich und billig und ermöglichen eine effiziente Wasserstoffproduktion unter stabilen Bedingungen, verbunden mit einem nützlichen und vorteilhaften oxidativen Prozess, bei dem z.B. die Alkalimetall-, Erdalkalimetall- oder Ammoniumsulfite zu den ökologisch weniger bedenklichen und gegebenenfalls wiederverwertbaren Sulfaten (z.B. als Gips), die Sulfide zu Schwefel bzw. Polysulfiden und die Hypophosphite und Phosphite zu Phosphaten oxidiert werden.

Als Edelmetall zur Beschichtung der Halbleiterpulver verwendet man bevorzugt Rhodium, Nickel, Osmium, Ruthenium oder Palladium und vor allem Platin, in einer Korngrösse von etwa 10 Å bis 1000 Å . Der Anteil Metall auf den Halbleiterpulvern liegt vorzugsweise zwischen 0,1 und 5 Gew.%, bezogen auf das Gewicht des Halbleiters. Geeignete Lichtquellen sind Sonnenlicht, besonders bei Verwendung von cadmiumhaltigen beschichteten Halbleiterpulvern, oder z.B. gegebenenfalls metallatomdotierte Quecksilberhochdrucklampen. Die Beschichtung der Halbleiterpulver mit den Metallen erfolgt mit Vorteil durch photokatalytische Abscheidung der Metalle auf den Halbleiterpulvern. Dabei werden die Halbleiterpulver, insbesondere Cadmium-Halbleiterpulver oder cadmiumhaltige Halbleiterpulver, zweckmässig unter Zusatz von Säuren oder Salzen davon, bevorzugt Essigsäure, in einer wässrigen Lösung oder Suspension einer geeigneten Metallverbindung oder eines Gemisches geeigneter Metallverbindungen, gegebenenfalls

in Gegenwart eines Puffers, suspendiert (pH vorzugsweise ca. 1,0 bis 9,0) und dann belichtet, vorzugsweise bei einer Temperatur zwischen 40 und 60°C. Dabei ist es von Vorteil, für die Beschichtung der Halbleiterpulver Lichtquellen mit einem hohen UV-C-Anteil (vgl. Houben-Weyl, Band Photochemie I, S. 42), z.B. Quecksilberhochdrucklampen, zu verwenden. Weitere Einzelheiten bezüglich des Einsatzes erfindungsgemäss thermisch behandelter Halbleiterpulver können den Beispielen entnommen werden.

Die Umsetzungen gemäss den folgenden Beispielen werden unter Normaldruck durchgeführt, soweit nichts anderes angegeben ist.

Beispiele 1-4: Jeweils ca. 20 g der in der folgenden Tabelle angegebenen Cadmiumsulfidpulver werden in ein 750 ml-Quarzrohr gegeben. Nach dem Spülen des Reaktors mit Stickstoff während 20 Minuten wird Stickstoff (ca. 2 l/h) eingeleitet und auf 490°C erhitzt. Diese Temperatur wird eine Stunde aufrechterhalten. Danach wird der Stickstoff durch Einleiten von $H_2S$ (ca. 2 l/h) verdrängt und die Temperatur auf 730°C erhöht. Das Cadmiumsulfidpulver wird eine Stunde bei dieser Temperatur gehalten und dann unter $H_2S$ auf 430°C abgekühlt. Schliesslich wird der Schwefelwasserstoff durch Einleiten von Stickstoff verdrängt und auf Raumtemperatur abgekühlt. In der folgenden Tabelle 1 sind einige Eigenschaften der Ausgangs- und Endprodukte gegenübergestellt.

Tabelle 1:

| Bsp. Nr. | CdS | spez. Oberfläche $m^2/g$ | Cl-Gehalt | Kristallinität |
|---|---|---|---|---|
| 1 | Fluka (puriss). Ausgangsprodukt | 2,25 | <45 ppm | gut |
| | nach thermischer Behandlung | 0,43 | <45 ppm | sehr gut |
| 2 | Siegfried (techn.)Ausgangsprodukt | 22,7 | 1,1 % | schlecht |
| | nach thermischer Behandlung | 1,49 | <31 ppm | gut |
| 3 | Alfa Ventron (elektron.Qualität) | | | |
| | Ausgangsprodukt | 1,31 | <45 ppm | sehr gut |
| | nach thermischer Behandlung | 0,30 | <45 ppm | sehr gut |
| 4 | nach Colour Index Nr. 77199 | | | |
| | Ausgangsprodukt | 6,6 | 295 ppm | gut |
| | nach thermischer Behandlung | 1,71 | 59 ppm | sehr gut |

Gemäss Untersuchung unter dem Elektronenmikroskop ist keine Veränderung der Teilchengrösse der CdS-Pulver eingetreten.

Die oben beschriebenen, unbehandelten und thermisch behandelten CdS-Pulver werden wie folgt mit Pt beschichtet und dann für die Wasserstoffproduktion mittels Photoredox-Reaktion eingesetzt:

0,4 g Hexachloroplatinsäurehydrat (Platingehalt 0,16 g) werden in 77,3 ml Wasser und 6 ml 0,1 N Salzsäure gelöst und mit konzentrierter $Na_2CO_3$-Lösung auf pH 7 gestellt. Man versetzt mit 2,0 g Kaliumacetat und 5 ml einer 5%igen wässrigen Lösung von $Cd(NO_3)_2 \cdot 4\ H_2O$ und stellt den pH mit 1,7 ml 96%iger Essigsäure auf 4,5. Dann gibt man jeweils 10g der oben beschriebenen Cadmiumsulfidpulver zu, entgast die Suspension während 30 Minuten bei 60°C und belichtet anschliessend 30 Minuten mit einer 125 W Quecksilberhochdrucklampe durch einen wassergekühlten Quarzfinger. Die erhaltene grüngraue Suspension wird abfiltriert, mit destilliertem Wasser nachgewaschen und im Trockenschrank bei 60°C /13000 Pa getrocknet.

Wasserstoffproduktion: Jeweils 0,4 g des platinbeschichteten Cadmiumsulfids werden in 90 ml einer 4,4%igen wässrigen Natriumsulfitlösung aufgeschlämmt und während 30 Minuten bei 60°C mit Stickstoff entgast. Dann wird die erhaltene Suspension bei 60°C in einem Photoreaktor, der mit einem Tauchfinger aus Pyrexglas und einer 125 W Quecksilberhochdrucklampe ausgestattet ist, bestrahlt. Der entwickelte Wasserstoff wird mit einer Gebürette gemessen. Die Resultate sind in der folgenden Tabelle 2 angegeben.

Tabelle 2:

| Katalysator (beschichteter Halbleiter) | $H_2$-Entwicklung ml/h |
|---|---|
| 0,4 g- CdS Fluka puriss.,unbehandelt, 1,3 Gew.% Pt | 27 |
| 0,4 g CdS Fluka puriss., thermisch behandelt, 1,08 Gew.% Pt | 46 |
| 0,4 g CdS Siegfried techn., unbehandelt, 1,5 Gew.% Pt | 0 |
| 0,4 g CdS Siegfried techn., thermisch behandelt, 1,32 Gew.% Pt | 24 |
| 0,4 g CdS Alfa Ventron, elektron. Qualität, unbehandelt, 1,5 Gew.% Pt | 25 |
| 0,4 g CdS Alfa Ventron, elektron. Qualität, thermisch behandelt, 1,5 Gew.% Pt | 78 |
| 0,4 g Cds nach Colour Index Nr. 77199, unbehandelt, 1,4 Gew.% Pt | 1 |
| 0,4 g CdS nach Colour Index Nr. 77199, therm. behandelt, 1,5 Gew.% Pt | 38 |

Beispiele 5-6: 20 g Cadmiumsulfid (Alfa Ventron, erhalten durch Ausfällen, spez. Oberfläche 26,7 $m^2/g$) werden in ein Quarzrohr gegeben. Nach dem Spülen des Reaktors mit Stickstoff während 20 Minuten wird Stickstoff eingeleitet (ca. 2 l/h) und auf 490°C erhitzt. Diese Temperatur wird eine Stunde gehalten. Anschliessend wird der Stickstoff durch Einleiten von $H_2S$ (ca. 2 l/h) verdrängt, und die Temperatur wird auf 730°C erhöht. Das Cadmiumsulfidpulver wird 1 Stunde bei dieser Temperatur gehalten, und dann unter $H_2S$ auf 430°C abgekühlt. Schliesslich wird der Schwefelwasserstoff durch Einleiten von Stickstoff verdrängt und auf Raumtemperatur abgekühlt.

Auf analoge Weise wird Cadmiumsulfid der obigen Qualität bei 805°C mit $H_2S$ behandelt. Als Kontrolle dient unbehandeltes Cadmiumsulfid.

Sämtliche Proben werden auf die in den Beispielen 1-4 beschriebene Weise mit Platin beschichtet und für die Wasserstoffproduktion eingesetzt. In der folgenden Tabelle sind einige Eigenschaften der erhaltenen Cadmiumsulfidproben sowie die Resultate bei der Wasserstoffproduktion zusammengefasst.

Tabelle 3:

| Bsp. Nr. | Temperatur der therm.Behandlung | spez. Oberfläche $m^2/g$ | Chlorgehalt | Pt Gehalt Gew.% | $H_2$-Produktion ml/h |
|---|---|---|---|---|---|
| 5 | 730 | 0,67 | <45 ppm | 1,5 | 24 |
| 6 | 805 | 0,21 | <45 ppm | 1,0 | 25 |
| Kontrolle unbehandelt | - | 26,7 | 0,14% | 1,5 | 2 |

Beispiel 7: 20 g Cadmiumsulfid (Fluka puriss., spez. Oberfläche 2,25 $m^2/g$) werden in ein offenes Quarzrohr gegeben, so dass die Probe der Luft ausgesetzt ist. Dann wird auf 730°C erhitzt, und diese Temperatur wird 90 Minuten gehalten. Anschliessend wird die Probe auf Raumtemperatur abgekühlt. Das so erhaltene Cadmiumsulfid weist eine spez. Oberfläche von 1,10 $m^2/g$ auf. 10 g dieses Cadmiumsulfids und 10 g unbehandeltes CdS werden wie in den Beispielen 1-4 beschrieben mit Platin beschichtet, jedoch unter Verwendung von 0,6 g Hexachlorplatinsäurehydrat anstelle von 0,4 g, und für die Wasserstoffproduktion eingesetzt.

| | $H_2$-Entwicklung |
|---|---|
| thermisch behandeltes CdS, 2,1 Gew.% Pt | 64 ml/h |
| unbehandeltes CdS, 1,3 Gew.% Pt | 27 ml/h. |

Beispiel 8: 20 g Cadmiumsulfid (Alfa Ventron, elektronische Qualität, spez. Oberfläche 1,31 $m^2/g$) werden in ein Quarzrohr gegeben. Der Luftdruck wird auf 2000 Pa gesenkt und während der thermischen Behandlung auf diesem Wert gehalten. Man erhitzt auf 505°C und hält diese Temperatur während 1 Std. Anschliessend wird auf Raumtemperatur abgekühlt. Das so erhaltene CdS weist eine spez. Oberfläche von 1,40 $m^2/g$ auf. 10 g dieses Cadmiumsulfids und 10 g unbehandeltes CdS werden wie in Beispiel 7 beschrieben mit Platin beschichtet und für die Wasserstoffproduktion eingesetzt.

| | $H_2$-Entwicklung |
|---|---|
| thermisch behandeltes CdS 1,76 Gew.% Pt | 37 ml/h |
| unbehandeltes CdS, 1,5 Gew.% Pt | 25 ml/h. |

Beispiele 9-10: 20 g Zinksulfid (Alfa Ventron, elektronische Qualität, spez. Oberfläche 33,5 $m^2/g$) werden in ein Quarzrohr gegeben. Nach dem Spülen des Reaktors mit Stickstoff während 20 Minuten wird Stickstoff eingeleitet (ca. 2 l/h) und auf 490°C erhitzt. Diese Temperatur wird 30 Minuten gehalten. Dann wird der Stickstoff durch Einleiten von $H_2S$ (ca. 2 l/h) verdrängt und auf 885°C erhitzt. Das Zinksulfidpulver wird 90 Minuten bei dieser Temperatur gehalten, dann unter $H_2S$ auf 420°C abgekühlt. Schliesslich wird der Schwefelwasserstoff durch Einleiten von Stickstoff verdrängt und auf Raumtemperatur abgekühlt.

Analog wird eine weitere Probe bei 980°C mit $H_2S$ behandelt. Die spezifische Oberfläche und die kristallinen Eigenschaften der so erhaltenen ZnS-Proben sind in der folgenden Tabelle 4 angegeben. Als Kontrolle dient unbehandeltes ZnS-Pulver.

Tabelle 4:

| Bsp. Nr. | Temp.d.therm. Behandlung °C | spez. Oberfläche $m^2/g$ | Kristallstruktur/Kristallinität |
|---|---|---|---|
| 9 | 885 | 0,79 | kubisch und Spuren von hexagonaler Struktur, sehr gut |
| 10 | 890 | 0,60 | do. |
| Kontrolle (unbehandelt) | | 33,5 | kubisch, sehr schlecht |

0,6 g Hexachloroplatinsäurehydrat (0,24 g Pt-Gehalt) werden in 82,3 ml Wasser und 5 ml 0,1 N Salzsäure gelöst und mit konz. $Na_2CO_3$-Lösung auf pH 7 gestellt. Man versetzt mit 2,0 g Kaliumacetat und stellt den pH mit 1,7 ml 96%iger Essigsäure auf 4,5. Dann gibt man 10 g unbehandeltes bzw. wie oben beschrieben thermisch behandeltes ZnS zu, entgast die Suspension während 30 Minuten bei 60°C und belichtet anschliessend 30 Minuten lang mit einer 125 W Quecksilberhochdrucklampe durch einen wassergekühlten Quarzfinger. Die erhaltene graue Suspension wird abfiltriert, mit destilliertem Wasser nachgewaschen und im Trockenschrank bei 60°C/13000 Pa getrocknet.

Die so erhaltenen Proben werden wie in den Beispielen 1-4 für die Produktion von Wasserstoff eingesetzt, wobei jedoch eine Quecksilberhochdrucklampe mit einem Tauchfinger aus Quarz eingesetzt wird.

| | $H_2$- Entwicklung |
|---|---|
| ZnS bei 885°C behandelt, 1,47 Gew.% Pt | 54 ml/h |
| ZnS bei 980°C behandelt, 2,04 Gew.% Pt | 43 ml/h |
| unbehandeltes ZnS, 2,3 Gew.% Pt | 12 ml/h. |

Beispiele 11-15: 20 Cadmiumzinksulfid (nach Colour Index Nr. 77117; Zusammensetzung $Cd_{0,86}Zn_{0,14}S$, spez. Oberfläche 5,02 $m^2/g$) werden in ein Quarzrohr gegeben. Nach dem Spülen des Reaktors mit Stickstoff wird im Stickstoffstrom (ca. 2 l/h) auf 490°C erhitzt. Diese Temperatur wird 45 Minuten gehalten. Dann wird der Stickstoff durch Einleiten von $H_2S$ verdrängt (ca. 2 l/h) und auf 760°C erhitzt. Diese Temperatur wird 90 Minuten aufrechterhalten. Schliesslich wird auf Raumtemperatur abgekühlt und der Schwefelwasserstoff wird durch Einleiten von Stickstoff verdrängt.

Analog werden vier weitere Proben behandelt, wobei entweder keine Vorbehandlung unter Stickstoff erfolgt oder diese bei 430°C, 310°C und 185°C vorgenommen wird. Als Kontrolle dient unbehandeltes Cadmiumzinksulfid-Pulver. In der folgenden Tabelle 5 sind einige Eigenschaften der erhaltenen Cadmiumzinksulfidpulver angegeben sowie die Wasserstoffentwicklung unter Verwendung von gemäss Beispiel 7 platinisiertem und danach wie dort angegeben für die Wasserstoffproduktion eingesetztem Cadmiumzinksulfid.

Tabelle 5:

| Bsp. Nr. | Temperatur der Behandlung mit $H_2S$ °C | Temperatur der Vorbehandlung unter $N_2$ °C | spez. Oberfläche $m^2/g$ | Kristall- /Kristallistruktur nität | Pt-Gehalt Gew.% | $H_2$-Entwicklung ml/h |
|---|---|---|---|---|---|---|
| 11 | 760 | 490 | 1,70 | eine hexagonale Phase, sehr gut | 1,3 | 40 |
| 12 | 760 | 430 | 1,71 | do. | 1,89 | 42 |
| 13 | 760 | 310 | 1,86 | do. | 1,58 | 40 |
| 14 | 760 | 185 | 1,40 | do. | 1,64 | 43 |
| 15 | 760 | keine Vorbehandlung mit $N_2$ | 1,67 | do. | 2,0 | 44 |
| Kontrolle | | - | 5,02 | zwei hexagonale Phasen, mittel bis gut | 1,3 | 9 |

Nach der thermischen Behandlung weisen die Proben die folgende Zusammensetzung auf:

$Cd_{0,85}Zn_{0,15}S$.

Beispiel 16:. 20 g Cadmiumsulfoselenid (nach Colour Index Nr. 77196; Zusammensetzung $CdS_{0,84}Se_{0,16}$, spez. Oberfläche 4,96 $m^2/g$) werden in ein Quarzrohr gegeben, bei 490°C während 45 Minuten mit Stickstoff vorbehandelt und anschliessend während 50 Minuten bei 760°C einem $H_2S$-Strom ausgesetzt. Nach dem Abkühlen auf 390°C wird der Schwefelwasserstoff durch Stickstoff verdrängt und auf Raumtemperatur abgekühlt. In der folgenden Tabelle 6 sind einige Eigenschaften der erhaltenen Proben angegeben.

Tabelle 6:

| Bsp. Nr. | thermische Behandlung | Zusammen-setzung | spez. Oberfläche $m^2/g$ | Kristallstruktur/ Kristallinität |
|---|---|---|---|---|
| 16 | $H_2S$, 760°C | $CdS_{0,88}Se_{0,12}$ | 0,31 | eine hexagonale Phase, gut |
| Kontrolle | - | $CdS_{0,84}Se_{0,16}$ | 4,96 | zwei hexagonale Phasen, mittel bis gut |

Jeweils 10 g der obigen Cadmiumsulfoselenidpulver werden wie in Beispiel 7 beschrieben platinisiert. Dann werden analog den Beispielen 1-4 jeweils 0,4 g jeder Probe in 90 ml einer Natriumsulfitlösung bzw. in 90 ml einer 5,5%igen wässrigen Lösung von $Na_2S \cdot 8\ H_2O$ aufgeschlämmt und mit Stickstoff entgast.Darauf werden die erhaltenen Suspensionen wie in den Beispielen 1-4 beschrieben bestrahlt ($\lambda > 300$ nm). Die Resultate sind in der folgenden Tabelle 7 angegeben.

Tabelle 7:

| thermische Behandlung | $H_2$-Entwicklung in $Na_2SO_3$ ml/h | $H_2$-Entwicklung in $Na_2S$ ml/h | Pt-Gehalt Gew.% |
|---|---|---|---|
| $H_2S$, 760°C | 13 | 62 | 2,2 |
| keine (Kontrolle) | 0 | 55 | 2,4 |

Beispiel 17: 20 g Cadmiumsilbersulfid (Zusammensetzung $Cd_{0,995}Ag_{0,010}S$, spez. Oberfläche 72,8 $m^2/g$) werden in ein Quarzrohr gegeben und wie in den Beispielen 1-4 beschrieben bei 760°C mit $H_2S$ behandelt. Die erhaltene Probe weist dieselbe Zusammensetzung wie das Ausgangsprodukt und eine spez. Oberfläche von 0,12 $m^2/g$ auf. 10 g dieses Cadmiumsilbersulfids sowie 10 g unbehandeltes Cadmiumsilbersulfid werden wie in Beispiel 7 beschrieben platinisiert. Je 0,4 g der mit Platin beschichteten Proben werden analog den Beispielen 1-4 für die Wasserstoffproduktion eingesetzt.

| | $H_2$-Entwicklung |
|---|---|
| thermisch behandeltes Cadmiumsilbersulfid, 0,9 Gew.% Pt | 44 ml/h |
| unbehandeltes Cadmiumsilbersulfid, 1,88 Gew.% Pt | 10 ml/h. |

Die gemäss den Beispielen 5-17 thermisch behandelten Halbleiterpulver weisen gemäss Untersuchung unter dem Elektronenmikroskop keine Veränderung der Teilchengrösse auf.

Patentansprüche:

1. Verfahren zur thermischen Behandlung von Halbleiterpulvern, dadurch gekennzeichnet, dass man bei einem Druck von 100 bis $10^6$ Pa

a) Halbleiterpulver aus CdS, CdSe, CdTe, $CdS_{1-x}Se_x$, $CdS_{1-x}Te_x$, $CdSe_{1-x}Te_x$, $Cd_{1-x}Zn_xS$, $Cd_{1-y}Ag_{2y}S$ oder $Cd_{1-y}Cu_yS$ in Gegenwart von $H_2S$, $H_2Se$, $H_2Te$ und/oder $CS_2$, gegebenenfalls im Gemisch mit Inertgasen und/oder mit bis zu 50 Volumenprozent $O_2$ oder in Gegenwart eines Gemisches aus Inertgasen und bis zu 50 Volumenprozent $O_2$ beim Siedepunkt des Cadmiums bei dem jeweils angewendeten Druck ± 100°C oder

b) Halbleiterpulver aus ZnS, ZnSe, ZnTe, $ZnS_{1-x}Se_x$, $ZnS_{1-x}Te_x$, $ZnSe_{1-x}Te_x$, $Zn_{1-y}Ag_{2y}S$ oder $Zn_{1-y}Cu_yS$ in Gegenwart von $H_2S$, $H_2Se$, $H_2Te$ und/oder $CS_2$, gegebenenfalls im Gemisch mit Inertgasen oder bis zu 50 Volumenprozent $O_2$ beim Siedepunkt des Zinks bei dem jeweils angewendeten Druck ± 150°C

behandelt, wobei x 0,01 bis 0,99 und y 0,0001 bis 0,20 sind.

2. Verfahren nach Anspruch 1, dadurch gekennzeichnet, dass man die thermische Behandlung gemäss Verfahrensvariante a) ausführt.

3. Verfahren nach Anspruch 1, dadurch gekennzeichnet, dass man ein CdS-, $CdS_{1-x}Se_x$-, $Cd_{1-x}Zn_xS$- oder $Cd_{1-y}Ag_{2y}S$-Halbleiterpulver verwendet, worin x 0,01 bis 0,4 und y 0,001 bis 0,2 sind.

4. Verfahren nach Anspruch 1, dadurch gekennzeichnet, dass man ein ZnS- oder $ZnS_{1-x}Se_x$-Halbleiterpulver verwendet, worin x 0,01 bis 0,4 ist.

5. Verfahren nach Anspruch 1, dadurch gekennzeichnet, dass man die Behandlung bei einem Druck von 1000 bis $2 \times 10^5$ Pa durchführt.

6. Verfahren nach Anspruch 1, dadurch gekennzeichnet, dass man die Behandlung bei Normaldruck durchführt.

7. Verfahren nach Anspruch 1, dadurch gekennzeichnet, dass man die Behandlung von Halbleiterpulvern gemäss Verfahrensvariante a) in Gegenwart von $H_2S$ oder Luft oder Gemischen davon vornimmt.

8. Verfahren nach Anspruch 1, dadurch gekennzeichnet, dass man die Behandlung von Halbleiterpulvern gemäss Verfahrensvariante b) in Gegenwart von $H_2S$ durchführt.

9. Verfahren nach Anspruch 1, dadurch gekennzeichnet, dass man ein CdS- oder $Cd_{1-x}Zn_xS$-Halbleiterpulver mit x = 0,05 bis 0,2 bei Normaldruck in Gegenwart von $H_2S$ bei 760 $\pm$ 60°C behandelt.

10. Verfahren nach Anspruch 1, dadurch gekennzeichnet, dass man ein CdS-Halbleiterpulver bei Normaldruck in Gegenwart von Luft bei 760 $\pm$ 60°C behandelt.

FO 7.3/DA/gs*